(19) Europäisches Patentamt
European Patent Office
Office européen des brevets

(11) **EP 1 579 511 B1**

(12) **EUROPÄISCHE PATENTSCHRIFT**

(45) Veröffentlichungstag und Bekanntmachung des Hinweises auf die Patenterteilung:
**28.03.2012 Patentblatt 2012/13**

(51) Int Cl.:
*H01L 33/22* (2010.01)     *H01L 21/308* (2006.01)
*H01L 21/033* (2006.01)

(21) Anmeldenummer: 03795768.5

(22) Anmeldetag: **18.12.2003**

(86) Internationale Anmeldenummer:
**PCT/DE2003/004197**

(87) Internationale Veröffentlichungsnummer:
**WO 2004/061980 (22.07.2004 Gazette 2004/30)**

(54) **VERFAHREN ZUM AUFRAUHEN EINER OBERFLÄCHE EINES OPTOELEKTRONISCHEN HALBLEITERKÖRPERS.**

METHOD FOR ROUGHENING A SURFACE OF AN OPTO-ELECTRONIC SEMICONDUCTOR BODY.

PROCÉDÉ POUR RENDRE RUGUEUSE LA SURFACE D'UN CORPS SÉMI-CONDUCTEUR OPTOÉLECTRONIQUE

(84) Benannte Vertragsstaaten:
**DE**

(30) Priorität: **30.12.2002 DE 10261426**
**18.02.2003 DE 10306779**

(43) Veröffentlichungstag der Anmeldung:
**28.09.2005 Patentblatt 2005/39**

(73) Patentinhaber: **OSRAM Opto Semiconductors GmbH**
**93055 Regensburg (DE)**

(72) Erfinder:
• **WINDISCH, Reiner**
**93186 Pettendorf (DE)**
• **WIRTH, Ralph**
**93138 Lappersdorf, (DE)**
• **ZULL, Heribert**
**93049 Regensburg (DE)**

(74) Vertreter: **Epping - Hermann - Fischer Patentanwaltsgesellschaft mbH Ridlerstrasse 55**
**80339 München (DE)**

(56) Entgegenhaltungen:
**US-A- 5 240 558     US-A- 5 676 853**
**US-A1- 2001 014 426**

• **PATENT ABSTRACTS OF JAPAN vol. 2002, no. 08, 5. August 2002 (2002-08-05) -& JP 2002 100609 A (SAKAI SHIRO;NITRIDE SEMICONDUCTOR CO LTD), 5. April 2002 (2002-04-05) -& EP 1 345 275 A (NITRIDE SEMICONDUCTORS CO LTD ;SAKAI SHIRO (JP)) 17. September 2003 (2003-09-17)**
• **STREUBEL K ET AL: "HIGH BRIGHTNESS ALGAINP LIGHT-EMITTING DIODES" IEEE JOURNAL OF SELECTED TOPICS IN QUANTUM ELECTRONICS, IEEE SERVICE CENTER, US, Bd. 8, Nr. 2, März 2002 (2002-03), Seiten 321-332, XP001143524 ISSN: 1077-260X**
• **SCHNITZER I ET AL: "30% EXTERNAL QUANTUM EFFICIENCY FROM SURFACE TEXTURED, THIN-FILM LIGHT-EMITTING DIODES" APPLIED PHYSICS LETTERS, AMERICAN INSTITUTE OF PHYSICS. NEW YORK, US, Bd. 63, Nr. 16, 18. Oktober 1993 (1993-10-18), Seiten 2174-2176, XP000404433 ISSN: 0003-6951**
• **WINDISCH R ET AL: "40% EFFICIENT THIN-FILM SURFACE-TEXTURED LIGHT-EMITTING DIODES BY OPTIMIZATION OF NATURAL LITHOGRAPHY" IEEE TRANSACTIONS ON ELECTRON DEVICES, IEEE INC. NEW YORK, US, Bd. 47, Nr. 7, Juli 2000 (2000-07), Seiten 1492-1498, XP000958488 ISSN: 0018-9383 in der Anmeldung erwähnt**

EP 1 579 511 B1

**Beschreibung**

Die Erfindung betrifft ein Verfahren zum Aufrauhen einer Oberfläche eines optoelektronischen Halbleiterkörpers, wobei das Aufrauhen mittels Ätzen erfolgt.

Die Druckschriften US 2001/0014426 A1 und US 5,676,853 offenbaren die Herstellung von Emitterspitzen von Feldemissionsdisplays.

Aufgerauhte Oberflächen können insbesondere im Zusammenhang mit lichtemittierenden Dioden (LED) vorteilhaft eingesetzt werden. Der Grund hierfür ist die Lichtauskopplung aus dem Halbleiterkörper, der die Grundlage für die LED bildet. Hier liegt im allgemeinen ein hoher Brechungsindexsprung vor, wobei der Brechungsindex des Halbleitermaterials typischerweise n = 3,5 beträgt. Das den Halbleiterkörper umgebende Harz hat einen Brechungsindex, der typischerweise n = 1,5 beträgt. Hieraus resultiert ein hoher Brechungsindexsprung für aus dem Halbleiterkörper austretende Strahlung. Es ergibt sich daraus ein kleiner Totalreflexionswinkel gegen die Harzumgebung, der ca. 26° beträgt. Dieser Totalreflexionswinkel führt dazu, daß nur ein Bruchteil des im Halbleiterkörper erzeugten Lichts ausgekoppelt werden kann. In der typischerweise bei der Herstellung verwendeten einfachen würfelförmigen Gestalt der LED bleibt ein Strahl, der nicht in den ca. 26° weiten Auskoppelkegel emittiert wird im Halbleiterkristall gefangen, da sein Winkel zu den Oberflächennormalen auch durch vielfache Flexion nicht verändert werden kann. Der Lichtstrahl wird infolgedessen früher oder später durch Absorption vor allem im Bereich des Kontakts, der aktiven Zone oder auch im Substrat verloren gehen.

Eine Aufrauhung der Oberfläche des Halbleiterkörpers kann nun vorteilhaft dafür eingesetzt werden, Strahlen die außerhalb des Auskoppelkegels propagieren in einen solchen zu streuen. Dies ist vor allem bei LED-Chips mit transparentem Substrat oder effektivem Spiegel unter der aktiven Zone, insbesondere auch bei Dünnfilm-LEDs, von Interesse. Diese Vorteile gelten auch bei organischen LEDs.

Aus der Druckschrift US 3,739,217 ist es bekannt, daß die Auskopplung von Licht aus Gallium-Phosphit-Kristallen durch Aufrauhen der Oberfläche verbessert werden kann.

Die Druckschrift JP 2002-100609 A beschreibt ein Verfahren zum Aufrauhen einer Halbleiteroberfläche mittels Ätzen einer auf diese aufgebrachten Schicht aus zwei Materialien, die sich bei Erwärmung uneinheitlich durchmischen.

Aus den Druckschriften R. Windisch et al., "40 % Efficient Thin-Film Surface-Textured Light-Emitting Diodes by Optimization of Natural Lithography", IEEE Transactions on Electron Devices, Vol. 47, No. 7, 2000, p 1492 - 1498, und I. Schnitzer et al; "30 % External Quantum Efficiency from Surface Textured, Thin-Film Light-Emitting Diodes"; Applied Physics Letters 63 (1993), pp. 2174-2176, ist es bekannt, Halbleiterkörper auf der Basis von Aluminium-Gallium-Arsenid aufzurauhen, um die Auskopplung von Licht aus dem Halbleiterkörper zu verbessern. Dabei wird ein im folgenden beschriebenes Verfahren zum Aufrauhen verwendet. Auf die Oberfläche des Halbleiterkörpers werden Kugeln aus Polystyrol aufgebracht. Diese können beispielsweise auf einer Wasseroberfläche in einer Monolage präpariert werden und dann auf die Oberfläche des Halbleiterkörpers durch Eintauchen transferiert werden. Nach dem Trocknen des Wassers haften die Kugeln auf der Oberfläche des Körpers. Anschließend wird die Oberfläche trockengeätzt, wodurch an den Orten der Kugeln Säulen stehen bleiben und der Raum zwischen den Säulen durch den Trockenätzprozeß vom Halbleiterkörper weggeätzt wurde.

Dieses bekannte Verfahren zum Aufrauhen der Oberfläche eines Körpers hat den Nachteil, daß es zur Anwendung bei Halbleiterkörpern aus dem Material Aluminium-Gallium-Indium-Phosphit oder Aluminium-Gallium-Indium-Nitrid nicht geeignet ist, zum Beispiel bei den in der Druckschrift Klaus Streubel et al.; "High Brightness AlGaInP Light Emitting Diodes"; IEEE Journal on Selected Topics in Quantum Electronics 8 (2002), Seiten 321-331 offenbarten AlGaInP-Leuchtdioden. Der Grund hierfür liegt darin, daß die verwendeten Trockenätzverfahren eine zu geringe Selektivität hinsichtlich der Polystyrol-Kugeln aufweisen. Dies bedeutet, daß der Halbleiterkörper nur sehr langsam im Vergleich zu den Kugeln geätzt wird, weswegen die als Ätzmaske dienenden Kugeln bereits zu einem sehr frühen Zeitpunkt des Ätzprozesses, wo nur eine sehr geringe Strukturtiefe in die Oberfläche des Körpers geätzt wurde, verschwunden sind. Dies hat zur Folge, daß das nötige Ätztiefe-zu-Strukturbreite-Verhältnis von 0,25 bis 5 nicht erreicht werden kann. Dieses Verhältnis wird benötigt, um die Auskopplung von Licht aus dem Halbleiterkörper effizient zu verbessern.

Es ist dabei Aufgabe der vorliegenden Erfindung, ein Verfahren zum Aufrauhen einer Oberfläche eines optoelektronischen Halbleiterkörpers anzugeben, das für viele verschiedene Materialien geeignet ist.

Diese Aufgabe wird gelöst durch ein Verfahren nach Patentanspruch 1. Vorteilhafte Ausgestaltungen des Verfahrens sind den abhängigen Patentansprüchen zu entnehmen.

Die Erfindung macht sich die Grundidee zu nutze, wonach das Problem der Selektivität der verwendeten Ätzverfahren entschärft werden kann, indem neben der Maskierung durch die Polystyrolkügelchen noch eine weitere Hilfsmaske verwendet wird. Diese Hilfsmaske besteht aus einem Material, das sowohl verschieden von dem Material des zu ätzenden Körpers, also des optoelektronischen Halbleiterkörpers, als auch verschieden von dem Material der Kugeln ist. Mit Hilfe dieser zusätzlichen Maske kann der Ätzprozeß in zwei Schritte unterteilt werden, wobei in einem ersten Schritt die Struktur der auf der Oberfläche angeordneten Kugeln in die Hilfsmaske übertragen wird. In einem zweiten Schritt wird nun die Struktur der Hilfsmaske in die Oberfläche des zu ätzenden Körpers übertragen.

Indem neben den Kugeln noch ein weiteres Material als Maske beteiligt ist, steht eine viel größere Auswahl von Materialkombinationen zur Verfügung, wobei hier die Prozesse hinsichtlich einer erhöhten Selektivität zwischen dem Maskenmaterial und dem zu ätzenden Material optimiert werden können. Beispielsweise gibt es Ätzverfahren, welche für eine bestimmte Materialkombination von Kugeln und zu ätzendem Körper ungeeignet sind. Diese Ätzverfahren können jedoch für die Durchführung des ersten Ätzschritts nach dem jetzt zweischrittigen Ätzverfahren verwendet werden. Darüber hinaus ist es nun möglich, den aufzurauhenden Körper mittels eines Verfahrens zu ätzen, das nicht notwendigerweise gegenüber den auf der Oberfläche liegenden Kugeln selektiv zu sein braucht. Vielmehr genügt es, wenn das zweite Ätzverfahren eine hohe Selektivität im Hinblick auf das Material der Hilfsmaske einerseits und im Hinblick auf den zu ätzenden Körper andererseits aufweist.

Es wird ein Verfahren zum Aufrauhen einer Oberfläche eines Körpers angegeben, das die folgenden Schritte umfaßt:

In einem ersten Schritt wird die Oberfläche des Körpers mit einer Maskenschicht beschichtet.

In einem darauf folgenden Schritt werden auf die Maskenschicht vorgeformte Maskenkörper aufgebracht.

In einem darauf folgenden Schritt wird die Maskenschicht durchgeätzt und zwar an Stellen, die von Maskenkörpern unbedeckt sind.

In einem darauf folgenden Schritt wird der Körper geätzt an Stellen seiner Oberfläche, die von der Maskenschicht freigelegt sind.

Das Verfahren hat den Vorteil, daß durch das Einbringen einer weiteren Ätzmaske der Ätzvorgang in zwei Schritte aufgespalten werden kann, wobei ein Ätzverfahren, das den Körper sehr selektiv gegenüber den vorgeformten Maskenkörpern ätzt nicht mehr benötigt wird. Vielmehr kann durch Variation der Materialien der Maskenkörper und der Maskenschicht ein breites Spektrum an möglichen Ätzverfahren der Eignung zugeführt werden, d.h., daß ein breiteres Spektrum an Ätzverfahren für den Ätzvorgang in Betracht kommt.

In einer Alternative des Verfahrens enthält der Körper Aluminium-Gallium-Indium-Phosphit (AlGaInP). Dieses Halbleitermaterial wird vorteilhaft verwendet für Leuchtdioden, die im roten oder im blauen Spektralbereich emittieren. Wahlweise wird dieses Halbleitermaterial auf Siliziumcarbid oder auf einem Gallium-Arsenid-Substrat abgeschieden.

In einer anderen Alternative des Verfahrens enthält der Körper Aluminium-Gallium-Indium-Nitrid (AlGaInN). Auch dieses Material ist für Leuchtdioden im roten oder blauen Spektralbereich besonders gut geeignet.

In einer Ausführungsform des Verfahrens wird eine Maskenschicht aufgebracht, die aus einem Dielektrikum besteht. Als Dielektrika kommen beispielsweise in Betracht $Si_XN_Y$, beispielsweise $Si_3N_4$, SiON, $SiO_2$, $Al_2O_3$ sowie weitere ähnliche Materialien. Vorzugsweise werden also Dielektrika für die Maskenschicht verwendet. Es können jedoch auch andere Materialien für die Maskenschicht geeignet sein. Entscheidend ist lediglich, daß sich das Material der Maskenschicht mit einem Ätzprozeß selektiv zu den Maskenkörpern ätzen läßt und daß sich der Körper mit einem weiteren, davon verschiedenen Ätzprozeß selektiv zur Maskenschicht ätzen läßt.

In einer Ausführungsform können für die vorgeformten Maskenkörper Kugeln aus Polystyrol verwendet werden. Aufgrund ihrer guten chemischen Stabilität und aufgrund der Möglichkeit, Polystyrol-Kugeln in großer Stückzahl mit einfachen und billigen Mitteln herstellen zu können, sind diese insbesondere für das hier beschriebene Verfahren als Maskenkörper geeignet.

Dabei können die Maskenkörper sowohl in Form einer zufälligen Anordnung als Monolage auf der Oberfläche der Maskenschicht aufgebracht werden als auch in Form einer regelmäßigen Anordnung.

In einer vorteilhaften Ausführungsform des Verfahrens werden die Ätzschritte mittels eines Trockenätzverfahrens durchgeführt. In Betracht kommen beispielsweise Verfahren wie reaktives Ionenätzen (RIE = Reactive Ion Etching), Ionenstrahlätzen (IBE = Ion Beam Etching) sowie chemisches unterstütztes Ionenstrahlätzen (CAIBE = Chemical Assisted Ion Beam Etching) usw.

Beispielsweise kommt es auch in Betracht, als Trockenätzverfahren ein induktiv gekoppeltes Plasma-Ätzverfahren (ICP = Inductive Coupled Plasma) zu verwenden.

Trockenätzverfahren haben bei dem vorliegenden Verfahren den Vorteil, daß auf die Verwendung von Flüssigkeiten verzichtet wird, was die örtliche Stabilität der Maskenkörper erhöht, da keine Strömungen in einer Flüssigkeit auftreten können.

In einer vorteilhaften Ausgestaltung des Verfahrens wird dieses so durchgeführt, daß in der Oberfläche des Körpers Strukturen stehen bleiben, für deren Breite b im Verhältnis zur Ätztiefe t gilt:

$$0{,}1 < t/b < 10.$$

Vorzugsweise wird das Verfahren so durchgeführt, daß gilt:

$$0{,}25 < t/b < 5.$$

Ein solches Tiefen-zu-Breiten-Verhältnis ist besonders vorteilhaft, um die Streuung an der Oberfläche von optischen Halbleiterkristallen zu verbessern, um die Auskopplung von Licht aus dem Kristall nach draußen zu verbessern.

Das genannte Ätztiefen-zu-Breiten-Verhältnis kann durch geeignete Wahl der Ätzprozesse sowie der Ausdehnung und dem Material der Maskenkörper erreicht werden.

In einer Variante des hier beschriebenen Verfahrens werden unmittelbar nach dem Durchätzen der Maskenschicht die Maskenkörper entfernt. In einer anderen Variante werden die Maskenkörper auf der Oberfläche der Maskenschicht gelassen, um dort als zusätzliche Ätzmaske während des zweiten Ätzprozesses zu dienen. Nach Ende der Ätzprozesse kann die Maskenschicht entfernt werden oder aber auch auf der Oberfläche des Körpers verbleiben.

Vorteilhafterweise wird das Verfahren so durchgeführt, daß die Ätztiefe in den Körper zwischen 50 und 100 nm beträgt. Eine solche Ätztiefe kann dadurch erreicht werden, daß ein Ätzprozeß mit einer geeigneten Selektivität zwischen der Maskenschicht und dem zu ätzenden Körper verwendet wird. Darüber hinaus muß auch die Ätzdauer geeignet gewählt werden, um die gewünschte Ätztiefe zu erreichen.

Vorzugsweise wird bei dem hier beschriebenen Verfahren die Maskenschicht mit einer Dicke zwischen 10 und 100 nm aufgebracht. Hierbei ist eine Mindestdicke für die Maskenschicht erforderlich, da sie ansonsten nicht zuverlässig als Maskierung des Körpers dienen kann. Eine bestimmte Maximaldicke sollte jedoch wiederum auch nicht überschritten werden, um die für das Durchätzen der Maskenschicht erforderliche Zeitdauer in Grenzen zu halten.

Um das weiter oben bereits beschriebene Verhältnis von Ätztiefe und Strukturbreite zu erreichen, ist es vorteilhaft, Maskenkörper zu verwenden, deren laterale Ausdehnung auf der Maskenschicht zwischen 150 und 300 nm liegt.

Das hier beschriebene Verfahren verwendet vorteilhaft für den ersten Ätzschritt einen Prozeß, der eine schlechte Selektivität hinsichtlich der Maskenkörper und des aufzurauhenden Körpers besitzt. Es ist dabei sogar daran zu denken, einen Prozeß zu verwenden, der die Maskenkörper stärker ätzt als den aufzurauhenden Körper, jedoch nur für den Fall, daß der Ätzprozeß hinsichtlich der Maskenschicht wiederum eine geeignete Selektivität aufweist.

Beispielsweise kann das Durchätzen der Maskenschicht mittels einer Anlage für reaktives Ionenätzen erfolgen.

Hierbei kann vorteilhafterweise ein Fluorprozeß zum Einsatz gelangen, wobei ein Gasgemisch von $CHF_3$ und Argon verwendet wird. Hierbei wird üblicherweise eine Standard-RIE-Anlage mit einem Parallel-Platten-Reaktor verwendet.

Der zweite Ätzschritt kann beispielsweise mittels einer ICP-Anlage durchgeführt werden, wobei als Ätzgas ein Gemisch aus $CH_4$ und $H_2$ verwendet wird.

Es wird darüber hinaus noch ein optoelektronisches Bauelement angegeben, das einen Halbleiterkörper aufweist. Dieser Halbleiterkörper enthält Aluminium-Gallium-Indium-Phosphit oder Aluminium-Gallium-Indium-Nitrid. Ferner ist die Oberfläche des Körpers strukturiert, wobei für die Breite der Strukturen im Vergleich zur Tiefe der Strukturen respektive der Ätztiefe gilt: 0,25 < t/b < 5. Es wird darüber hinaus dasselbe Bauelement angegeben, wobei jedoch der Halbleiterkörper anstelle von Aluminium-Gallium-Indium-Phosphit Aluminium-Gallium-Indium-Nitrid enthält. Solche optoelektronischen Bauelemente, beispielsweise LED, können mit Hilfe des hier vorgestellten Verfahrens erstmals hergestellt werden. Die aus dem Stand der Technik bekannten Verfahren sind zur Herstellung des hier beschriebenen Verhältnisses von t zu b nicht geeignet.

Dabei ist unter dem Begriff "Strukturen" dasjenige zu verstehen, was nach dem Ätzen des Halbleiterkörpers aus dessen Oberfläche hervorragt. Die Breite dieser Strukturen könnte beispielsweise die Breite der in der Druckschrift R. Windisch et al., "40 % Efficient Thin-Film Surface-Textured Light-Emitting Diodes by Optimization of Natural Lithography", IEEE Transactions on Electron Devices, Vol. 47, No. 7, 2000, p 1492 - 1498 beschriebenen Säulen oder Türme sein.

Im folgenden wird die Erfindung anhand eines Ausführungsbeispiels und den dazugehörigen Figuren näher erläutert:

Figur 1    zeigt einen zu ätzenden Körper, auf den eine Maskenschicht und Maskenkörper aufgebracht sind.

Figur 2    zeigt den Körper aus Figur 1 nach dem ersten Ätzschritt.

Figur 3    zeigt den Körper aus Figur 2 nach dem zweiten Ätzschritt.

Figur 4    zeigt den Körper aus Figur 3 nach Entfernen der Maskenschicht.

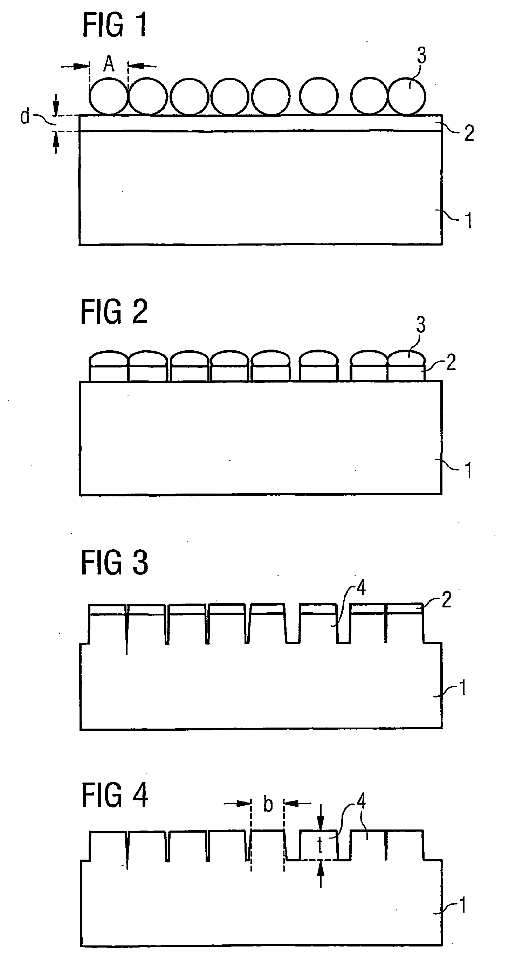

Es wird darauf hingewiesen, daß alle Figuren 1 bis 4 eine schematische Querschnittsansicht darstellen. Es wird ferner drauf hingewiesen, daß gleiche Bezugszeichen gleiche Elemente oder wenigstens Elemente mit gleicher oder ähnlicher Funktion kennzeichnen.

Figur 1 zeigt einen Körper 1, der beispielsweise ein Halbleiterkörper sein kann. Auf einer Oberfläche des Körpers 1 ist eine Maskenschicht 2 aufgebracht. Die Maskenschicht 2 weist vorteilhafterweise eine Dicke d auf, die zwischen 10 und 100 nm liegt.

Auf die Maskenschicht 2 aufgebracht sind Maskenkörper 3, die in dem hier betrachteten Spezialfall zum einen eine Monolage bilden und zum anderen die Form von Kugeln haben. Die laterale Ausdehnung A der Kugeln beträgt dabei zwischen 150 und 300 nm. Es können aber auch Maskenkörper mit anderen Formen und anderen geeigneten Materialien verwendet werden.

In Figur 2 ist gezeigt, wie die Anordnung nach Figur 1 nach dem ersten Ätzschritt aussieht. Die Maskenschicht 2 ist an den Stellen, an denen sie von Maskenkörpern 3 unbedeckt ist, durchgeätzt worden. Dementsprechend resultiert eine durchlöcherte Maskenschicht 2, wobei auf der Oberfläche der Maskenschicht 2 noch immer Maskenkörper 3 angeordnet sind. Die Maskenkörper 3 sind jedoch durch im allgemeinen nicht vermeidbare Ätzungen etwas im Volumen reduziert gegenüber der Darstellung in Figur 1. Dies resultiert daraus, daß fast alle Ätzverfahren, die zum Ätzen der Maskenschicht 2 eingesetzt werden, immer auch, und sei es auch nur in einem sehr geringen Ausmaß, die Maskenkörper 3 ätzen.

Anschließend werden die Maskenkörper 3 auf der Oberfläche der Maskenschicht 2 entfernt. Dieser Schritt ist jedoch nicht zwingend, vielmehr ist es auch möglich, die Maskenkörper 3 auf der Oberfläche der Maskenschicht 2 zu belassen.

Figur 3 zeigt den Zustand der Anordnung nach Figur 1, wobei jedoch bereits der zweite Ätzschritt vonstatten gegangen ist. Dies bedeutet, daß die Oberfläche des Körpers 1 bereits Strukturen 4 aufweist. Auf der Oberfläche der Strukturen 4 sind noch die Reste der Maskenschicht 2 übriggeblieben.

Figur 4 zeigt die Anordnung nach Figur 3 nach dem Entfernen der Maskenschicht 2. Es resultieren Strukturen 4, deren Breite b im Verhältnis zur Ätztiefe t die folgende Bedingung erfüllen:

$$0,25 \; < \; t/b \; < \; 5.$$

Die Strukturen 4 können beispielsweise die Form von zylinderförmigen Türmchen haben.

Die Strukturen 4 können entweder regelmäßig entlang eines im Vorfeld durch die Anordnung der Maskenkörper 3 definierten Rasters positioniert sein. Die Strukturen 4 können jedoch auch zufällig über die Oberfläche des Körpers 1 verteilt sein.

**Patentansprüche**

1. Verfahren zum Aufrauhen einer Oberfläche eines optoelektronischen Halbleiterkörpers (1), der AlGaInN oder AlGaInP enthält,
   mit folgenden Schritten:

   a) Beschichten der Oberfläche mit einer Maskenschicht (2)
   b) Aufbringen von vorgeformten Maskenkörpern (3) auf der Maskenschicht (2)
   c) Durchätzen der Maskenschicht (2) an von Maskenkörpern (3) unbedeckten Stellen
   d) Ätzen des Halbleiterkörpers (1) an von der Maskenschicht (2) freien Stellen seiner Oberfläche.

2. Verfahren nach Anspruch 1,

   wobei die Maskenschicht (2) aus einem Dielektrikum besteht.

3. Verfahren nach Anspruch 2, wobei das Dielektrikum aus einem Material der folgenden Gruppe ausgewählt ist: $Si_xN_y$, $Si_3N_4$, SiON, $SiO_2$ $Al_2O_3$.

4. Verfahren nach einem der Ansprüche 1 bis 3, wobei als vorgeformte Maskenkörper (3) Kugeln aus Polystyrol verwendet werden.

5. Verfahren nach einem der Ansprüche 1 bis 4, wobei die Ätzschritte mittels eines Trockenätzverfahrens durchgeführt werden.

6. Verfahren nach einem der Ansprüche 1 bis 5, wobei das Verfahren so durchgeführt wird, daß in der Oberfläche des Halbleiterkörpers (1) Strukturen (4) stehen bleiben, für deren Breite (b) im Verhältnis zur Ätztiefe (t) gilt:

   $$0,1 \; < \; t/b \; < \; 10.$$

7. Verfahren nach Anspruch 6,
   wobei das Verfahren so durchgeführt wird, daß in der Oberfläche des Halbleiterkörpers (1) Strukturen (4) stehen bleiben, für deren Breite (b) im Verhältnis zur Ätztiefe (t) gilt:

   $$0,25 \; < \; t/b \; < \; 5.$$

8. Verfahren nach einem der Ansprüche 1 bis 7, wobei unmittelbar nach Schritt c) die Reste der Maskenkörper (3) von der Maskenschicht (2) entfernt werden.

9. Verfahren nach einem der Ansprüche 1 bis 8, wobei die Ätztiefe (t) in dem Halbleiterkörper (1) zwischen 50 und 100 nm beträgt.

10. Verfahren nach einem der Ansprüche 1 bis 9, wobei die Maskenschicht (2) mit einer Dicke (d) zwischen 10 und 100 nm aufgebracht wird.

11. Verfahren nach einem der Ansprüche 1 bis 10, wobei die Maskenkörper (3) auf der Maskenschicht (2) eine laterale Ausdehnung (A) zwischen 150 und 300 nm aufweisen.

12. Verfahren nach einem der Ansprüche 1 bis 11, wobei der erste Ätzschritt mittels eines Prozeßschritts erfolgt, der die Maskenkörper (3) stärker ätzt als den Halbleiterkörper (1).

**13.** Verfahren nach einem der Ansprüche 1 bis 12, wobei das Durchätzen der Maskenschicht (2) mittels einer Anlage für reaktives Ionenätzen erfolgt.

**14.** Verfahren nach Anspruch 13, wobei als Ätzgas eine Mischung aus $CHF_3$ und Ar verwendet wird.

**15.** Verfahren nach einem der Ansprüche 1 bis 14, wobei das Ätzen des Halbleiterkörpers (1) mittels einer Anlage erfolgt, die für ein induktiv gekoppeltes Plasma geeignet ist.

**16.** Verfahren nach Anspruch 15, wobei als Ätzgas eine Mischung aus $CH_4$ und $H_2$ verwendet wird.

**Claims**

**1.** Method for roughening a surface of an optoelectronic semiconductor body (1) containing AlGaInN or AlGaInP,
having the following steps of:

   a) coating the surface with a mask layer (2)
   b) applying preformed mask bodies (3) on the mask layer (2)
   c) etching through the mask layer (2) at locations not covered by mask bodies (3)
   d) etching the semiconductor body (1) at locations of its surface that are free of the mask layer (2).

**2.** Method according to Claim 1, the mask layer (2) consisting of a dielectric.

**3.** Method according to Claim 2, the dielectric being selected from a material of the following group: $Si_xN_y$, $Si_3N_4$, SiON, $SiO_2$, $Al_2O_3$.

**4.** Method according to one of Claims 1 to 3, balls made of polystyrene being used as preformed mask bodies (3).

**5.** Method according to one of Claims 1 to 4, the etching steps being carried out by means of a dry etching method.

**6.** Method according to one of Claims 1 to 5, the method being carried out in such a way that structures (4) remain in the surface of the semiconductor body (1), for the width (b) of which structures in relation to the etching depth (t) the following holds true:

$$0.1 < t/b < 10.$$

**7.** Method according to Claim 6, the method being carried out in such a way that structures (4) remain in the surface of the semiconductor body (1), for the width (b) of which structures in relation to the etching depth (t) the following holds true:

$$0.25 < t/b < 5.$$

**8.** Method according to one of Claims 1 to 7, the residues of the mask body (3) being removed from the mask layer (2) immediately after step c).

**9.** Method according to one of Claims 1 to 8, the etching depth (t) in the semiconductor body (1) being between 50 and 100 nm.

**10.** Method according to one of Claims 1 to 9, the mask layer (2) being applied with a thickness (d) of between 10 and 100 nm.

**11.** Method according to one of Claims 1 to 10, the mask bodies (3), on the mask layer (2), having a lateral extent (A) of between 150 and 300 nm.

**12.** Method according to one of Claims 1 to 11, the first etching step being effected by means of a process step which etches the mask bodies (3) to a greater degree than the semiconductor body (1).

**13.** Method according to one of Claims 1 to 12, the etching through the mask layer (2) being effected by means of an installation for reactive ion etching.

**14.** Method according to Claim 13, a mixture of $CHF_3$ and Ar being used as etching gas.

**15.** Method according to one of Claims 1 to 14, the semiconductor body (1) being etched by means of an installation suitable for an inductively coupled plasma.

**16.** Method according to Claim 15, a mixture of $CH_4$ and $H_2$ being used as etching gas.

**Revendications**

**1.** Procédé servant à rendre rugueuse une surface d'un corps opto-électronique semi-conducteur (1) qui contient du AlGaInN ou du AlGaInP, le procédé comportant les étapes suivantes :

   a) revêtement de la surface par une couche de masque (2),
   b) application de corps de masque (3) préfaçonnés sur la couche de masque (2),
c) gravure de la couche de masque (2) à travers les emplacements non recouverts par les corps de masque (3) et
d) gravure du corps semi-conducteur (1) sur les emplacements de sa surface non recouverts par la couche de masque (2).

2. Procédé selon la revendication 1, dans lequel la couche de masque (2) est constituée d'un diélectrique.

3. Procédé selon la revendication 2, dans lequel le diélectrique est sélectionné dans un matériau de l'ensemble suivant : $Si_xN_y$, $Si_3N_4$, SiON, $SiO_2$, $Al_2O_3$ .

4. Procédé selon l'une des revendications 1 à 3, dans lequel des billes de polystyrène sont utilisées comme corps de masque (3) préfaçonnés.

5. Procédé selon l'une des revendications 1 à 4, dans lequel les étapes de gravure sont exécutées au moyen d'un procédé de gravure à sec.

6. Procédé selon l'une des revendications 1 à 5, dans lequel le procédé est exécuté de telle sorte que des structures (4) dont le rapport entre la largeur (b) et la profondeur de gravure (t) vérifie la relation :

$$0,1 < t/b < 10$$

restent dans la surface du corps semi-conducteur (1).

7. Procédé selon la revendication 6, exécuté de telle sorte que des structures (4) dont le rapport entre la largeur (b) et la profondeur de gravure (t) vérifie la relation :

$$0,25 < t/b < 5$$

restent dans la surface du corps semi-conducteur (1).

8. Procédé selon l'une des revendications 1 à 7, dans lequel les résidus des corps de masque (3) sont enlevés de la couche de masque (2) immédiatement après l'étape c).

9. Procédé selon l'une des revendications 1 à 8, dans lequel la profondeur de gravure (t) dans le corps semi-conducteur (1) est comprise entre 50 et 100 nm.

10. Procédé selon l'une des revendications 1 à 9, dans lequel la couche de masque (2) est appliquée à une épaisseur (d) comprise entre 10 et 100 nm.

11. Procédé selon l'une des revendications 1 à 10, dans lequel les corps de masque (3) présentent sur la couche de masque (2) une extension latérale (A) comprise entre 150 et 300 nm.

12. Procédé selon l'une des revendications 1 à 11, dans lequel la première étape de gravure s'effectue au moyen d'une étape de traitement qui grave les corps de masque (3) plus fortement que le corps semi-conducteur (1).

13. Procédé selon l'une des revendications 1 à 12, dans lequel la gravure à travers la couche de masque (2) s'effectue au moyen d'une installation de gravure par ions réactifs.

14. Procédé selon la revendication 13, qui utilise comme gaz de gravure un mélange de $CHF_3$ et d'Ar.

15. Procédé selon l'une des revendications 1 à 14, dans lequel la gravure du corps semi-conducteur (1) s'effectue au moyen d'une installation qui permet de coupler un plasma par voie inductive.

16. Procédé selon la revendication 15, qui utilise comme gaz de gravure un mélange de $CH_4$ et de $H_2$.

## FIG 1

## FIG 2

## FIG 3

## FIG 4

8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20010014426 A1
- US 5676853 A
- US 3739217 A
- JP 2002100609 A

**In der Beschreibung aufgeführte Nicht-Patentliteratur**

- **R. Windisch et al.** 40 % Efficient Thin-Film Surface-Textured Light-Emitting Diodes by Optimization of Natural Lithography. *IEEE Transactions on Electron Devices,* 2000, vol. 47 (7), 1492-1498
- **I. Schnitzer et al.** 30 % External Quantum Efficiency from Surface Textured, Thin-Film Light-Emitting Diodes. *Applied Physics Letters,* 1993, vol. 63, 2174-2176
- **Druckschrift Klaus Streubel et al.** High Brightness AlGaInP Light Emitting Diodes. *IEEE Journal on Selected Topics in Quantum Electronics,* 2002, vol. 8, 321-331
- **Druckschrift R. Windisch et al.** 40 % Efficient Thin-Film Surface-Textured Light-Emitting Diodes by Optimization of Natural Lithography. *IEEE Transactions on Electron Devices,* 2000, vol. 47 (7), 1492-1498